# EUROPEAN PATENT APPLICATION

(11) **EP 4 791 134 A1**
(43) Date of publication of application: **12.08.2026**
(21) Application number: 26155726.8
(22) Date of filing: 02.02.2026
(51) Int. Cl.: H05K 7/20

(54) **COOLANT DISTRIBUTION UNIT EQUIPMENT**

(30) Priority: 05.02.2025 US 202563754008 P; 29.05.2025 US 202563813719 P; 07.01.2026 CN 202610015326
(71) Applicant: Lite-On Technology Corporation, Taipei City 11492 (TW)
(72) Inventor: LIN, Yu-Hsi, Taipei City (TW); CHEN, Wen-Chi, 114 Taipei City (TW); MAU, Shu-Hua, Taoyuan City (TW); CHIU, Yung-Chang, Taipei City (TW)
(74) Representative: Viering, Jentschura & Partner mbB Patent- und Rechtsanwälte

(57) **Abstract**

A coolant distribution unit (CDU) equipment (100) includes a chassis (1), a heat exchanger (2), two fluidic path modules (41, 42), an electronic circuit module (5), and a plurality of transmission wires (6). An interior space of the chassis (1) has a fluidic module placement region (12) and an electronic circuit module placement region (11) that is located above the fluidic module placement region (12). The heat exchanger (2) and the two fluidic path modules (41, 42) are arranged in the fluidic module placement region (12), and the two fluidic path modules (41, 42) are fluidly coupled to the heat exchanger (2). One of the two fluidic path modules (41, 42) includes a pump unit (421). The electronic circuit module (5) is arranged in the electronic circuit module placement region (11) and includes a plurality of electronic circuit units (51) having a pump driving unit (511). At least one of the transmission wires (6) is electrically connected to the pump unit (421) and the pump driving unit (511).

## Description

### FIELD OF THE INVENTION

The present invention relates to a cooling equipment, and more particularly to a coolant distribution unit (CDU) equipment.

### BACKGROUND OF THE INVENTION

Internal components of a conventional coolant distribution unit (CDU) equipment do not have a suitable configuration, which is not conducive to proper utilization of the internal space of the conventional CDU equipment, such that the conventional CDU equipment cannot be reduced in size.

### SUMMARY OF THE INVENTION

In response to the above-referenced technical inadequacies, the present invention provides a coolant distribution unit (CDU) equipment for effectively improving on the issues associated with conventional CDU equipment.

In order to solve the above-mentioned problems, one of the technical aspects adopted by the present invention is to provide a coolant distribution unit (CDU) equipment, which includes a chassis, a heat exchanger, a first fluidic path module, a second fluidic path module, an electronic circuit module, and a plurality of transmission wires. The chassis has a fluidic module placement region and an electronic circuit module placement region that is arranged above the fluidic module placement region. The heat exchanger is disposed in the fluidic module placement region. The first fluidic path module and the second fluidic path module are disposed in the fluidic module placement region and are fluidly coupled to the heat exchanger. The first fluidic path module includes a first input fluidic path and a first output fluidic path, and the second fluidic path module includes a second input fluidic path and a second output fluidic path. The electronic circuit module is disposed in the electronic circuit module placement region. The electronic circuit module includes a plurality of electronic circuit units having a first pump driving unit. The second fluidic path module has a first pump unit, and at least one of the plurality of transmission wires is electrically connected to the first pump unit and the first pump driving unit.

Therefore, the interior space of the CDU equipment in the present invention is provided with a suitable configuration (e.g., the electronic circuit module placement region of the chassis is arranged above the fluidic module placement region) to achieve effective utilization, thereby effectively reducing the size of the CDU equipment.

These and other aspects of the present invention will become apparent from the following description of the embodiment taken in conjunction with the following drawings and their captions, although variations and modifications therein may be effected without departing from the scope of the novel concepts of the invention.

### BRIEF DESCRIPTION OF THE DRAWINGS

The described embodiments may be better understood by reference to the following description and the accompanying drawings, in which:
FIG. 1 is a schematic diagram showing fluidic paths of a coolant distribution unit (CDU) equipment according to one embodiment of the present invention;
FIG. 2 is a schematic perspective view of the CDU equipment according to one embodiment of the present invention;
FIG. 3 is a schematic exploded view of FIG. 2;
FIG. 4 is a schematic top view of FIG. 3 when a top plate of a chassis is omitted;
FIG. 5 is a schematic cross-sectional view taken along line V-V of FIG. 2;
FIG. 6A is a schematic exploded view of FIG. 3 when the top plate of the chassis and transmission wires are omitted;
FIG. 6B is a schematic exploded view of FIG. 3;
FIG. 6C is a schematic exploded view of FIG. 3 from another angle of view;
FIG. 7 is a schematic top view showing a tray and an electronic circuit module of FIG. 6A;
FIG. 8 is a schematic bottom view showing a tray and an electronic circuit module of FIG. 6A;
FIG. 9 is a perspective view showing a heat exchanger, a first fluidic path module, and a second fluidic path module of FIG. 6A;
FIG. 10 is a perspective view showing the heat exchanger, the first fluidic path module, and the second fluidic path module of FIG. 6A from another angle of view;
FIG. 11 is a schematic exploded view of FIG. 9;
FIG. 12 is a schematic exploded view of FIG. 10; and
FIG. 13 is a schematic top view of FIG. 9.

### DETAILED DESCRIPTION OF THE EXEMPLARY EMBODIMENTS

The present invention is more particularly described in the following examples that are intended as illustrative only since numerous modifications and variations therein will be apparent to those skilled in the art. Like numbers in the drawings indicate like components throughout the views. As used in the description herein and throughout the claims that follow, unless the context clearly dictates otherwise, the meaning of "a," "an" and "the" includes plural reference, and the meaning of "in" includes "in" and "on." Titles or subtitles can be used herein for the convenience of a reader, which shall have no influence on the scope of the present invention.

The terms used herein generally have their ordinary meanings in the art. In the case of conflict, the present document, including any definitions given herein, will prevail. The same thing can be expressed in more than one way. Alternative language and synonyms can be used for any term(s) discussed herein, and no special significance is to be placed upon whether a term is elaborated or discussed herein. A recital of one or more synonyms does not exclude the use of other synonyms. The use of examples anywhere in this specification including examples of any terms is illustrative only, and in no way limits the scope and meaning of the present invention or of any exemplified term. Likewise, the present invention is not limited to various embodiments given herein. Numbering terms such as "first," "second" or "third" can be used to describe various components, signals or the like, which are for distinguishing one component/signal from another one only, and are not intended to, nor should be construed to impose any substantive limitations on the components, signals or the like.

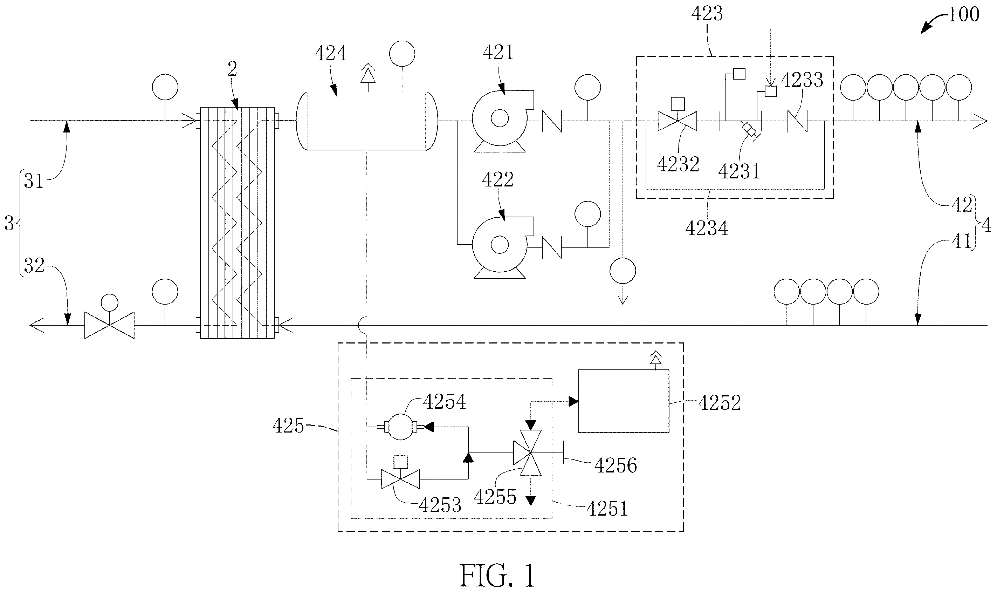

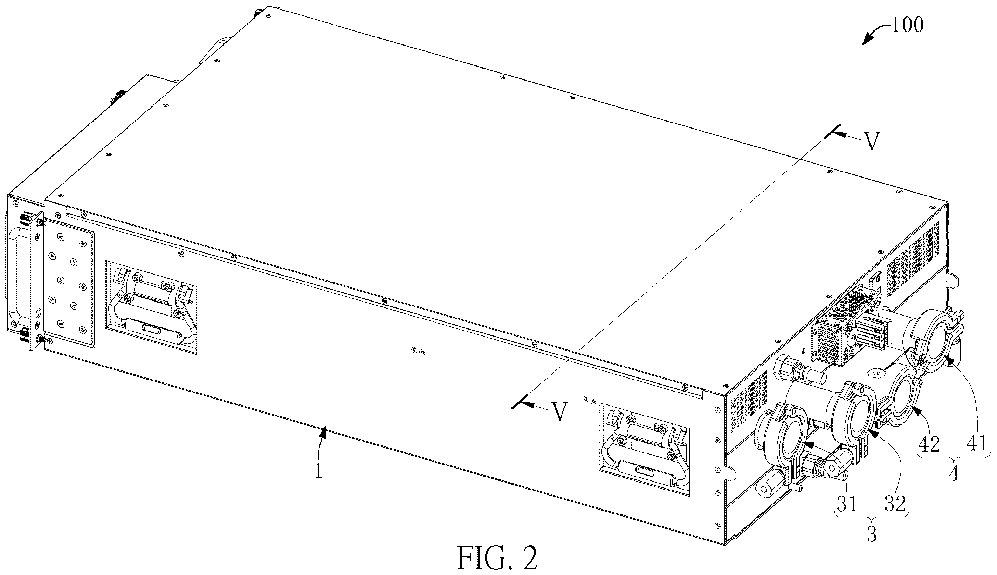

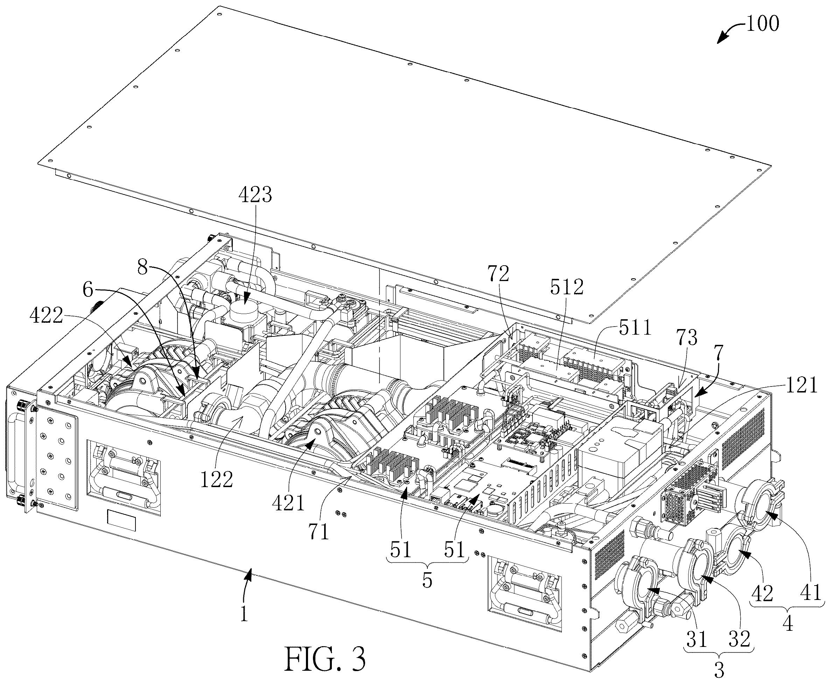

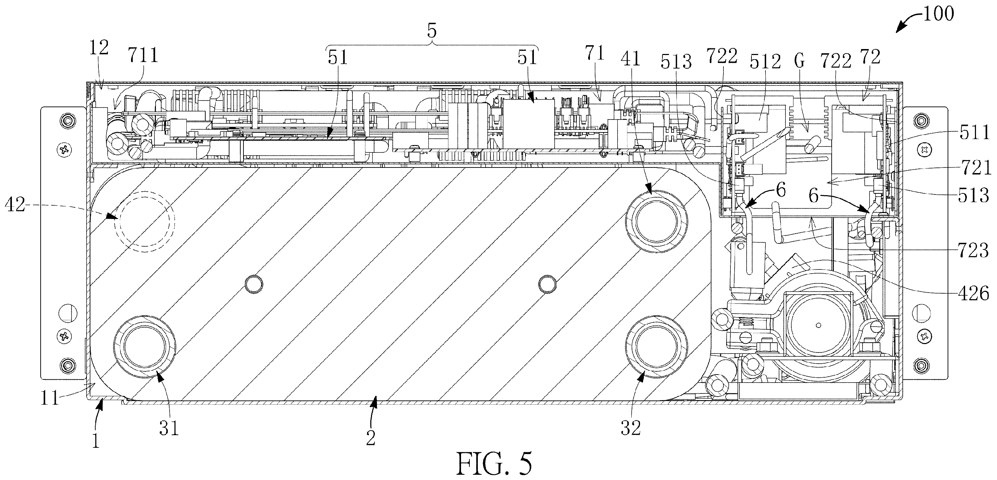

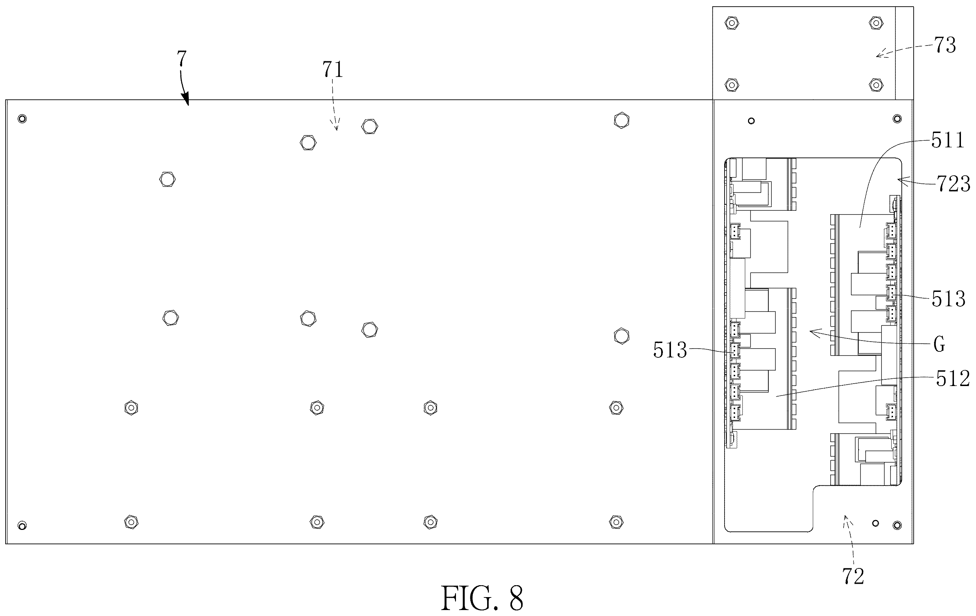

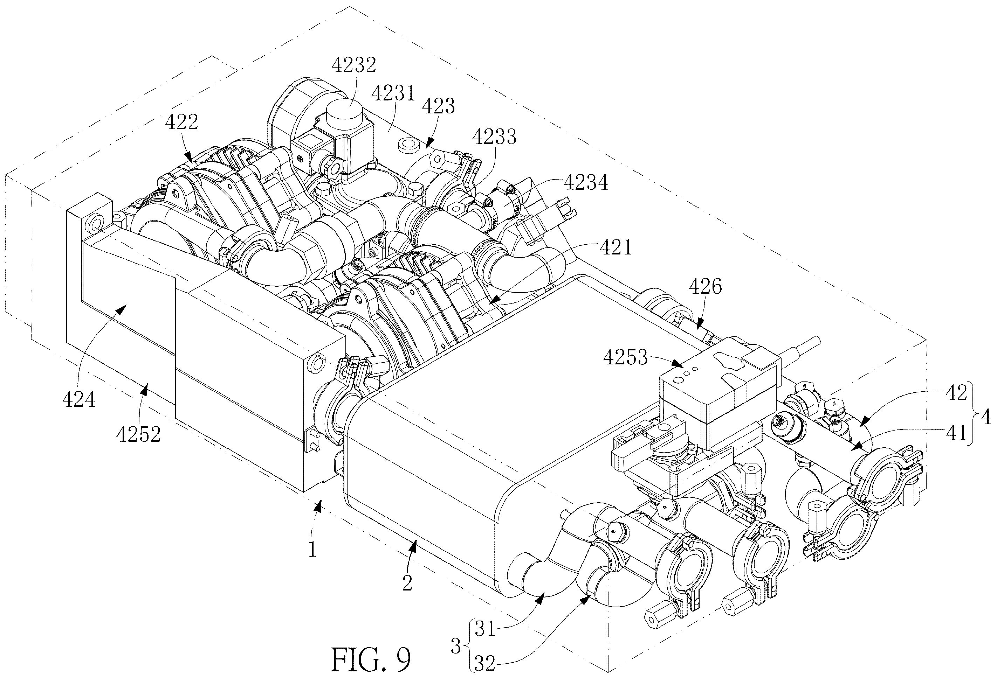

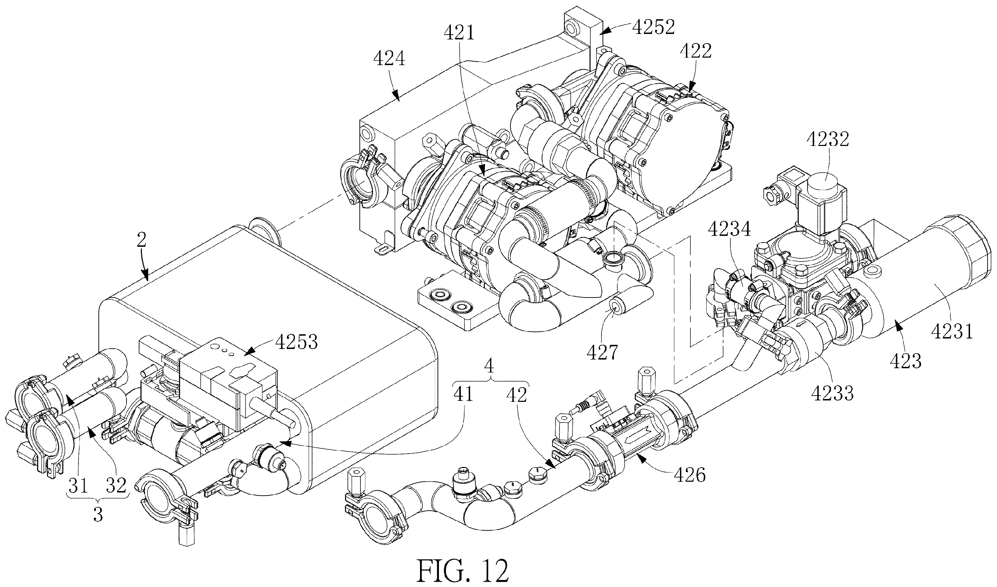

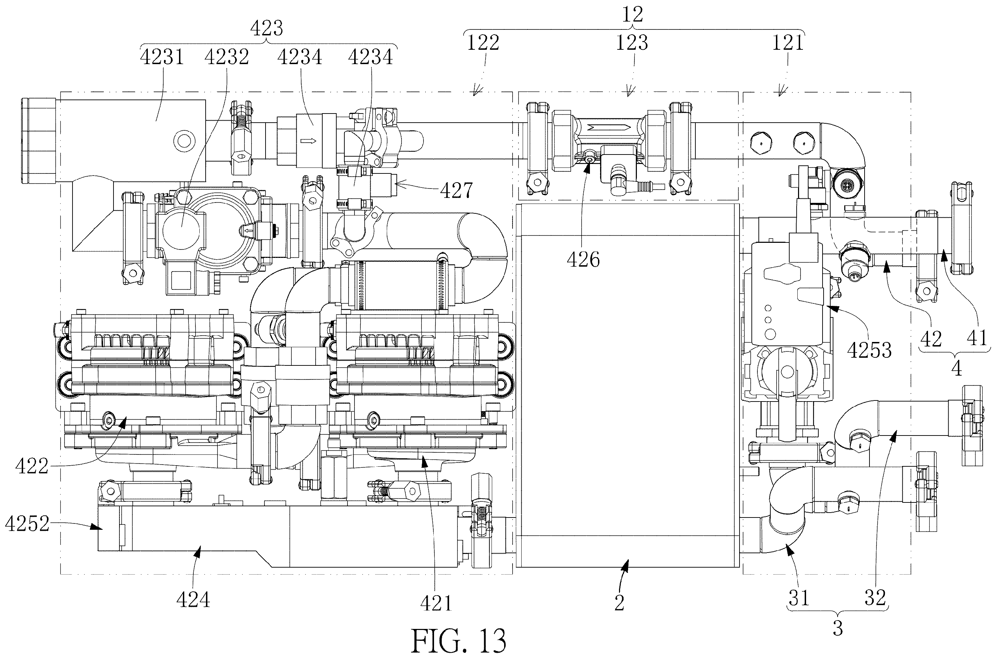

Referring to FIG. 1 to FIG. 13, at least one embodiment of the present invention is provided. The present embodiment provides a coolant distribution unit (CDU) equipment 100. FIG. 1 shows a schematic diagram of fluidic paths of the CDU equipment 100 according to one embodiment, and FIG. 2 to FIG. 13 show one of specific structures of the CDU equipment 100 shown in FIG. 1, but the present invention is not limited thereto. It should be noted that some drawings, for the convenience of illustrating the corresponding descriptions, are provided by having transmission wires (e.g., electrical wires and signal wires), sensors (e.g., temperature sensors and pressure sensors), and fluid pipes (e.g., hoses) omitted.

The CDU equipment 100 includes a chassis 1, a heat exchanger 2, a first fluidic path module 3, a second fluidic path module 4, an electronic circuit module 5, and a plurality of transmission wires 6. The heat exchanger 2, the first fluidic path module 3, the second fluidic path module 4, the electronic circuit module 5, and the transmission wires 6 are disposed in the chassis 1.

Specifically, the chassis 1 (e.g., an interior space of the chassis 1) has an electronic circuit module placement region 11 and a fluidic module placement region 12. The heat exchanger 2, the first fluidic path module 3, and the second fluidic path module 4 are disposed in the fluidic module placement region 12, and the electronic circuit module 5 is disposed in the electronic circuit module placement region 11. The electronic circuit module placement region 11 is preferably arranged adjacent to a top side (e.g., a top plate) of the chassis 1, such that the electronic circuit module placement region 11 is spatially isolated from the fluidic module placement region 12 for reducing the probability of damage to the electronic circuit module 5 due to leakage. Furthermore, the electronic circuit module 5 is concentrated in a same region (i.e., the electronic circuit module placement region 11), thereby reducing space required for separate arrangement of the electronic circuit module 5 and improving convenience of maintenance operations of the electronic circuit module 5. In one embodiment, the CDU equipment 100 includes a tray 7 assembled to the chassis 1, the electronic circuit module placement region 11 is arranged in the tray 7, and the CDU equipment 100 has no electronic circuit unit 51 disposed outside of the tray 7; in other words, all of the electronic circuit units 51 of the electronic circuit module 5 are concentrated in the tray 7 for achieving the above advantages.

It should be noted that the electronic circuit module placement region 11 is arranged above the fluidic module placement region 12, which can be described as follows. In one embodiment, a top boundary of the electronic circuit module placement region 11 is arranged above a top boundary of the fluidic module placement region 12. In another embodiment, the fluidic module placement region 12 is mostly arranged below a bottom boundary of the electronic circuit module placement region 11, and a part of the fluidic module placement region 12 is arranged on a lateral side of the electronic circuit module placement region 11 and is not higher than the top boundary of the electronic circuit module placement region 11. In yet another embodiment, along a transversal projection direction of the CDU equipment 100 (e.g., in a longitudinal cross section that covers the electronic circuit module placement region 11 and the fluidic module placement region 12), a projection area of the electronic circuit module placement region 11 is at least partially overlapped with a projection area of the fluidic module placement region 12.

In one embodiment, the heat exchanger 2 can be a plate heat exchanger (PHE). In one embodiment, through the arrangement of the heat exchanger 2, the fluidic module placement region 12 is divided into a first chamber 121 located at one side of the heat exchanger 2, a second chamber 122 located at another side of the heat exchanger 2, and a connection channel 123 that is in fluid communication with the first chamber 121 and the second chamber 122. A volume of the second chamber 122 is greater than a volume of the first chamber 121, and the volume of the first chamber 121 is greater than a volume of the connecting channel 123.

The first fluidic path module 3 and the second fluidic path module 4 are fluidly coupled to the heat exchanger 2. In one embodiment, a part of the first fluidic path module 3 and a part of the second fluidic path module 4 are located in the heat exchanger 2 and are spaced apart from each other for being configured to exchange heat energy with each other.

The first fluidic path module 3 has a first input fluidic path 31 and a first output fluidic path 32 for transmitting a cooled facility fluid into the heat exchanger 2. The second fluidic path module 4 has a second input fluidic path 41 and a second output fluidic path 42 for transmitting a coolant has cooled IT equipment into the heat exchanger 2. The facility fluid and the coolant can exchange heat energy in the heat exchanger 2 to cool the coolant. In one embodiment, the first input fluidic path 31, the first output fluidic path 32, and the second input fluidic path 41 are arranged in the first chamber 121, and the second output fluidic path 42 is arranged along the second chamber 122, the connection channel 123, and the first chamber 121.

Specifically, the second fluidic path module 4 has a first pump unit 421. In one of embodiment, the first pump unit 421 can be arranged in the second output fluidic path 42; in another embodiment, the first pump unit 421 can be arranged in the second input fluidic path 41 according to practical requirements.

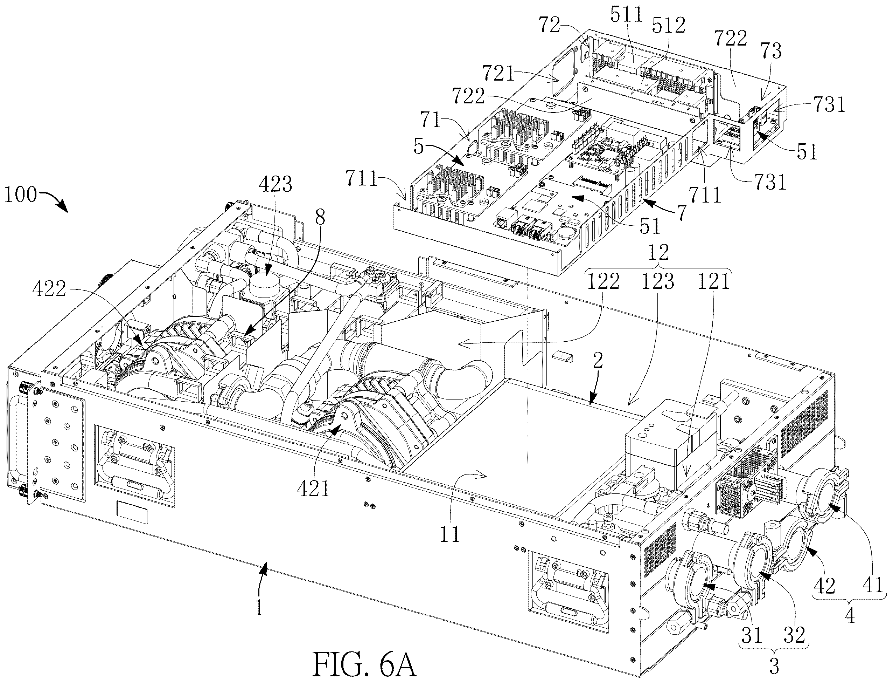

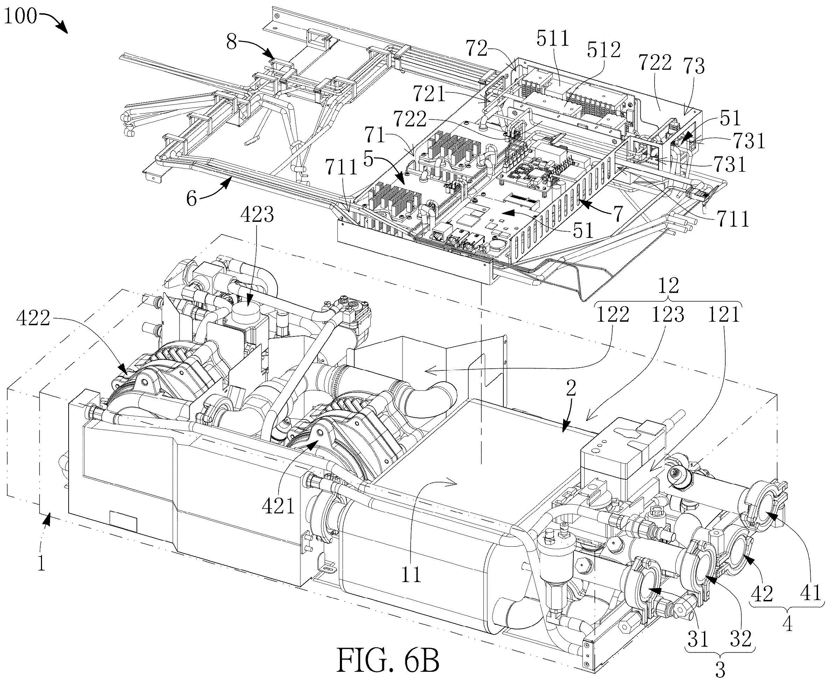

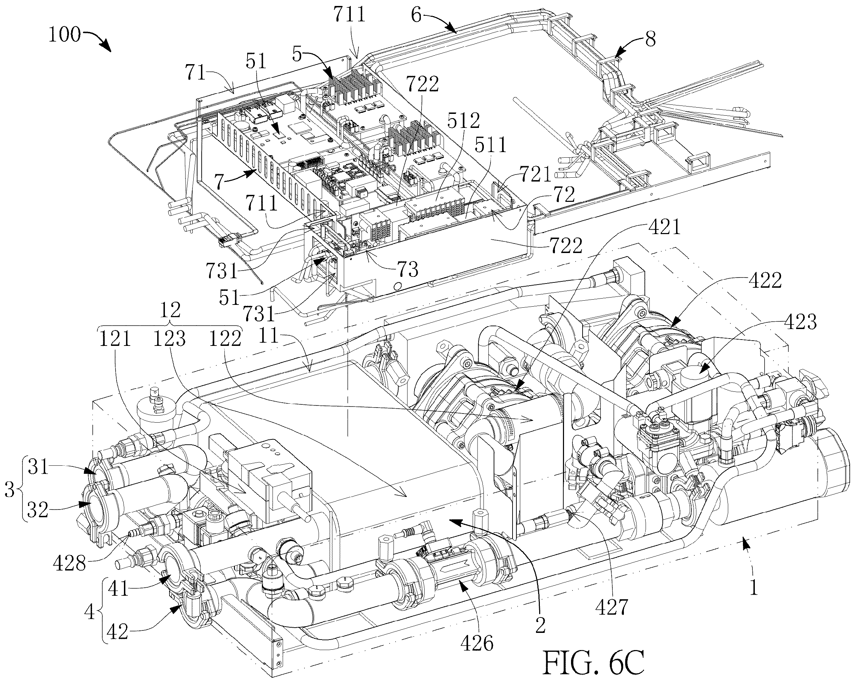

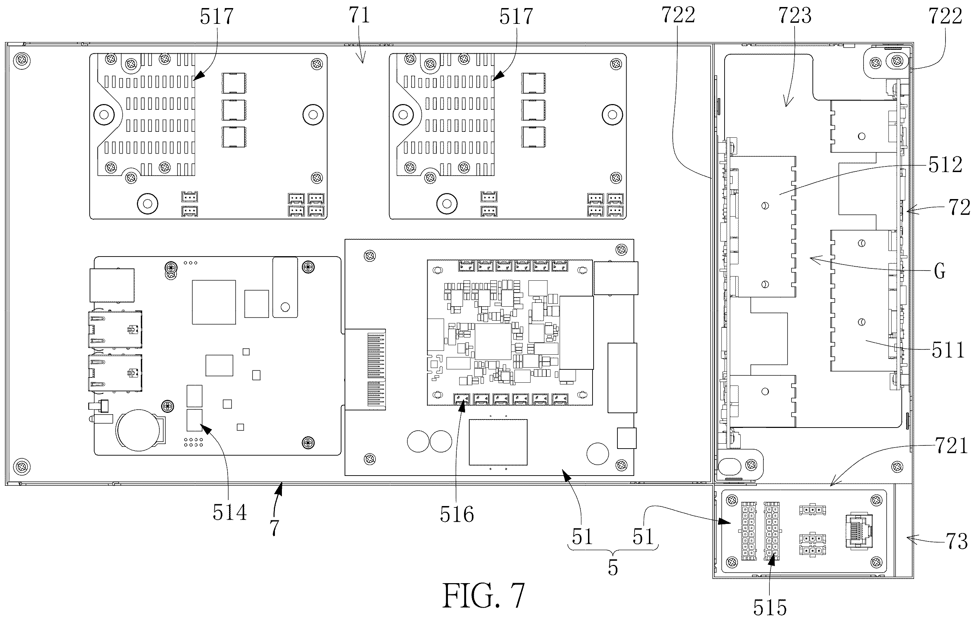

As shown in FIG. 6A to FIG. 8, the electronic circuit module 5 includes a plurality of electronic circuit units 51 having a first pump driving unit 511. At least one of the transmission wires 6 is electrically connected to the first pump unit 421 and the first pump driving unit 511 (not shown in the drawings). In one embodiment, the electronic circuit units 51 further include at least one of a power conversion unit, a logic control unit, a signal transmission unit, a sensor control unit, and an electronic protection unit; for example, as shown in FIG. 7, the electronic circuit units 51 can include the logic control unit 514, the signal transmission unit 515, the sensor control unit 516, and the electronic protection unit 517.

In one embodiment, the second fluidic path module 4 further includes a second pump unit 422, the electronic circuit units 51 include a second pump driving unit 512 that is electrically connected to the second pump unit 422 through at least one of the transmission wires 6, and the first pump unit 421 and the second pump unit 422 are arranged in parallel.

The first pump unit 421 and the second pump unit 422 can be arranged in the second input fluidic path 41 or the second output fluidic path 42. In one embodiment, the first pump unit 421 and the second pump unit 422 are arranged in the second output fluidic path 42. In one embodiment, the first pump unit 421 and the second pump unit 422 can be driven in turns. In another embodiment, the first pump unit 421 and the second pump unit 422 can also be driven individually according to practical requirements.

In one embodiment, the CDU equipment 100 includes a tray 7 assembled to the chassis 1, and the electronic circuit module placement region 11 is arranged in the tray 7. In one embodiment, the tray 7 is detachably assembled to the chassis 1; for example, the tray 7 can be fixed in the chassis 1 in a screwing manner or a locking manner for facilitating installation and subsequent maintenance. In one embodiment, the tray 7 is located above at least one of the first fluidic path module 3, the second fluidic path module 4, and the heat exchanger 2 (e.g., the tray 7 is substantially located above the heat exchanger 2 and the connection channel 123).

As shown in FIG. 6A to FIG. 8, in one embodiment, the tray 7 includes a first accommodating portion 71 and a second accommodating portion 72 that is connected to and in fluid communication with the first accommodating portion 71. In one embodiment, the first accommodating portion 71 is located above the heat exchanger 2, and the second accommodating portion 72 is suspended above the connection channel 123. In one embodiment, a volume of the first accommodating portion 71 is greater than a volume of the second accommodating portion 72, and a slot depth of the second accommodating portion 72 is greater than a slot depth of the first accommodating portion 71.

In one embodiment, lateral walls of the first accommodating portion 71 have at least one first lateral opening 711 that provides for at least one of the transmission wires 6 to pass therethrough (not shown in the drawings). At least one of the electronic circuit units 51 is assembled to a slot bottom of the first accommodating portion 71, and can be electrically coupled to a component located outside of the first accommodating portion 71 through at least one of the transmission wires 6.

In one embodiment, as shown in FIG. 6A to FIG. 7, lateral walls 722 of the second accommodating portion 72 have at least one second lateral opening 721 that provides for at least one of the transmission wires 6 to pass therethrough (not shown in the drawings). In one embodiment, the second accommodating portion 72 has two lateral walls 722 facing toward each other, and at least one of the electronic circuit units 51 is assembled to one of the two lateral walls 722 and is spaced apart from another one of the two lateral walls 722 by a gap G. In another embodiment, at least two of the electronic circuit units 51 (e.g., the first pump driving unit 511 and the second pump driving unit 512) are respectively assembled to the two lateral walls 722 and are spaced apart from each other by the gap G.

In one embodiment, the second accommodating portion 72 has a bottom opening 723 arranged on a slot bottom thereof, and the second fluidic path module 4 includes a flow meter 426 arranged below the bottom opening 723. In one embodiment, the bottom opening 723 is in fluid communication with the gap G, so that the user can observe a detection value of the flow meter 426 of the second fluidic path module 4 through the gap G and the bottom opening 723. Accordingly, at least one of the electronic circuit units 51 in the second accommodating portion 72 can be electrically coupled to a component located outside of the second accommodating portion 72 through at least one of the transmission wires 6 that passes through the at least one second lateral opening 721 or the bottom opening 723. In one embodiment, at least one of the electronic circuit units 51 assembled in the second accommodating portion 72 has a circuit port 513 facing toward the bottom opening 723, and at least one of the transmission wires 6 is connected to the circuit port 513 by passing through the bottom opening 723.

In one embodiment, the tray 7 includes a third accommodating portion 73, and at least one of the electronic circuit units 51 is assembled to a slot bottom of the third accommodating portion 73 and can be electrically coupled to a component located outside of the third accommodating portion 73 through at least one of the transmission wires 6 (not shown in the drawings). The third accommodating portion 73 and the second accommodating portion 72 are connected to each other and are in fluid communication with each other for providing at least one of the transmission wires 6 to pass therethrough. Specifically, a volume of the third accommodating portion 73 is less than the volume of the second accommodating portion 72, and a slot depth of the third accommodating portion 73 is greater than the slot depth of the second accommodating portion 72.

In one embodiment, the third accommodating portion 73 protrudes from the first accommodating portion 71; for example, two ends of the second accommodating portion 72 are respectively flush with two of the lateral walls of the first accommodating portions 71, and the third accommodating portion 73 is connected to one of the two ends of the second accommodating portion 72. Moreover, lateral walls of the third accommodating portion 73 have at least one third lateral opening 731 that provides for at least one of the transmission wires 6 to pass therethrough.

In one embodiment, the CDU equipment 100 further includes a wire bracket 8 assembled to the chassis 1, and at least one of the transmission wires 6 is arranged along the wire bracket 8. In one embodiment, the wire bracket 8 is detachably assembled to the chassis 1. In one embodiment, the wire bracket 8 is located higher than the fluidic module placement region 11, thereby making better usage of the interior space of the chassis 1 and preventing damage caused by leakage.

In one embodiment, the second fluidic path module 4 includes a filtering fluidic path 423 that is fluidly coupled to the heat exchanger 2 and that is provided for filtering the coolant, and the filtering fluidic path 423 can be arranged in the second input fluidic path 41 or the second output fluidic path 42. In one embodiment, the filtering fluidic path 423 is arranged in the second output fluidic path 42.

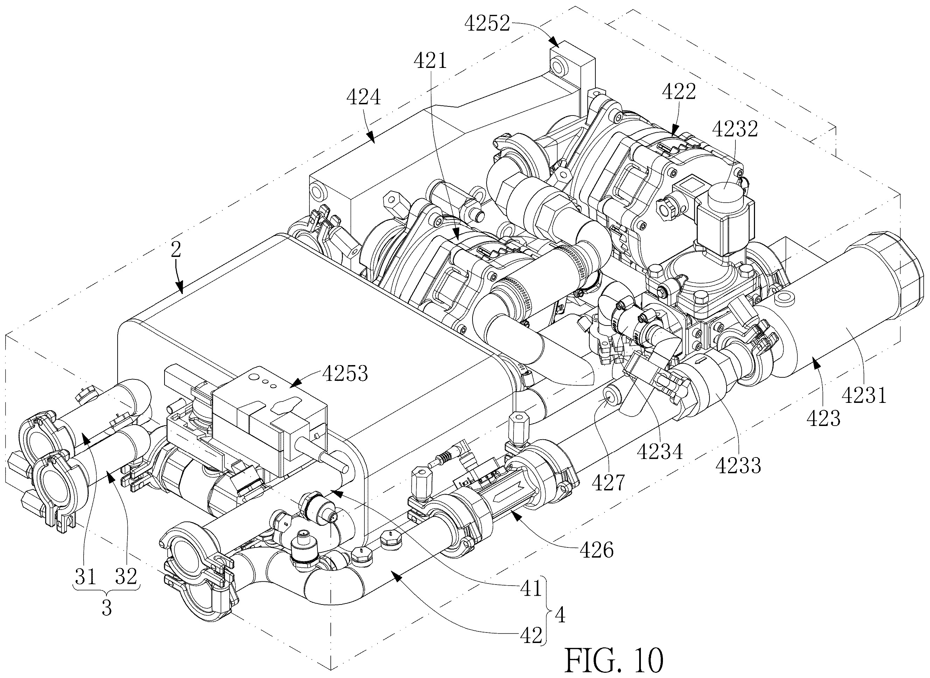

In one embodiment, the filtering fluidic path 423 includes a filter 4231, a solenoid valve 4232 being in fluid communication with an upstream of the filter 4231, and a check valve 4233 that is in fluid communication with a downstream of the filter 4231. The solenoid valve 4232 is arranged on a downstream of the first pump unit 421 and the second pump unit 422. In one embodiment, the filter 4231 is located at a corner of the chassis 1, and a part of the filter 4231 passes through the chassis 1 (as shown in FIG. 10), thereby allowing a filter core of the filter 4231 to be replaced without opening the chassis 1.

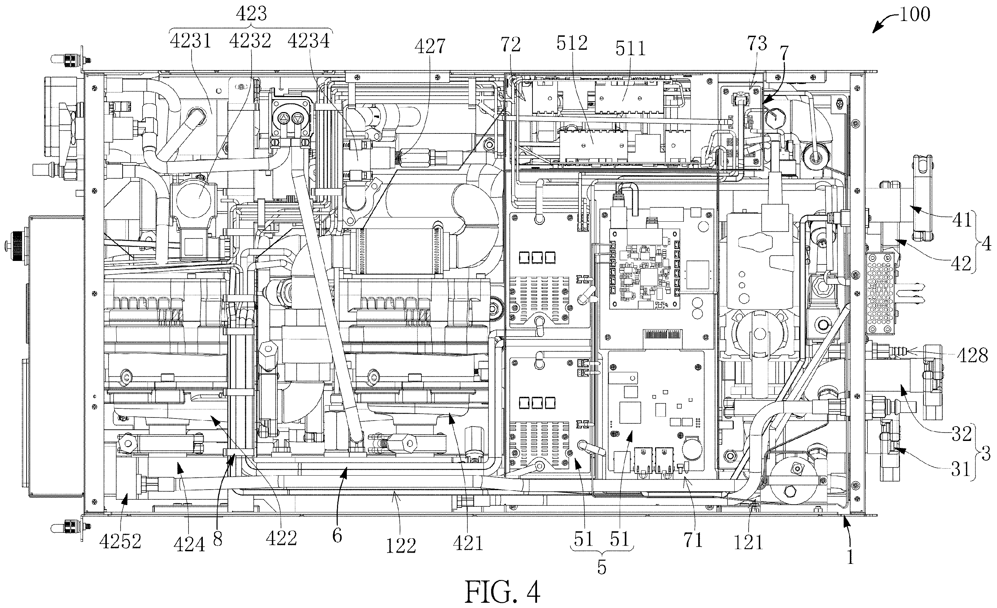

In one embodiment, the filtering fluidic path 423 includes a bypass pipe 4234 having two ends that are respectively in fluid communication with an upstream of the solenoid valve 4232 and a downstream of the check valve 4233, and the bypass pipe 4234 can be arranged in the second input fluidic path 41 or the second output fluidic path 42. In one embodiment, the bypass pipe 4234 is arranged in the second output fluidic path 42. In another embodiment, the second output fluidic path 42 can selectively have a pressure relief pipe 427 (as shown in FIG. 4, FIG. 6C, FIG. 10, and FIG. 12) that is in fluid communication with an upstream of the bypass pipe 4234 and the downstream of the first pump unit 421 and the second pump unit 422, and the pressure relief pipe 427 can be cooperated with a pressure relief valve 428 arranged outside of the chasses 1 by being connected to at least one pipe (not labeled in the drawings), thereby facilitating a pressure relief operation.

Accordingly, the solenoid valve 4232 can be closed for preventing fluid (e.g., the coolant) from flowing toward the filter 4231, so that the second output fluidic path 42 is in operation by establishing a bypass fluidic path through the bypass pipe 4234, and the filter core of the filter 4231 can be disassembled and replaced without affecting the operation of the CDU equipment 100.

In one embodiment, the second fluidic path module 4 includes a fluidic storage tank 424 that is fluidly coupled to the heat exchanger 2 and that is in fluid communication with an upstream of the first pump unit 421 (and the second pump unit 422). The fluidic storage tank 424 can be arranged in the second input fluidic path 41 or the second output fluidic path 42. In one embodiment, the fluidic storage tank 424 is arranged in the second output fluidic path 42 for accommodating the coolant after heat exchange.

In one embodiment, the CDU equipment 100 includes a pressure adjustment fluidic path 425 that is fluidly coupled to the fluidic storage tank 424, and the pressure adjustment fluidic path 425 will be arranged in either the second input fluidic path 41 or the second output fluidic path 42 according to the location of the fluidic storage tank 424. In one embodiment, the pressure adjustment fluidic path 425 and the fluidic storage tank 424 are arranged in the second output fluidic path 42.

In one embodiment, the pressure adjustment fluidic path 425 includes a pressure adjustment unit 4251 connected to the fluidic storage tank 424 and a buffering tank 4252 that is connected to the pressure adjustment unit 4251. In one embodiment, the fluidic storage tank 424 is stacked on the buffering tank 4252.

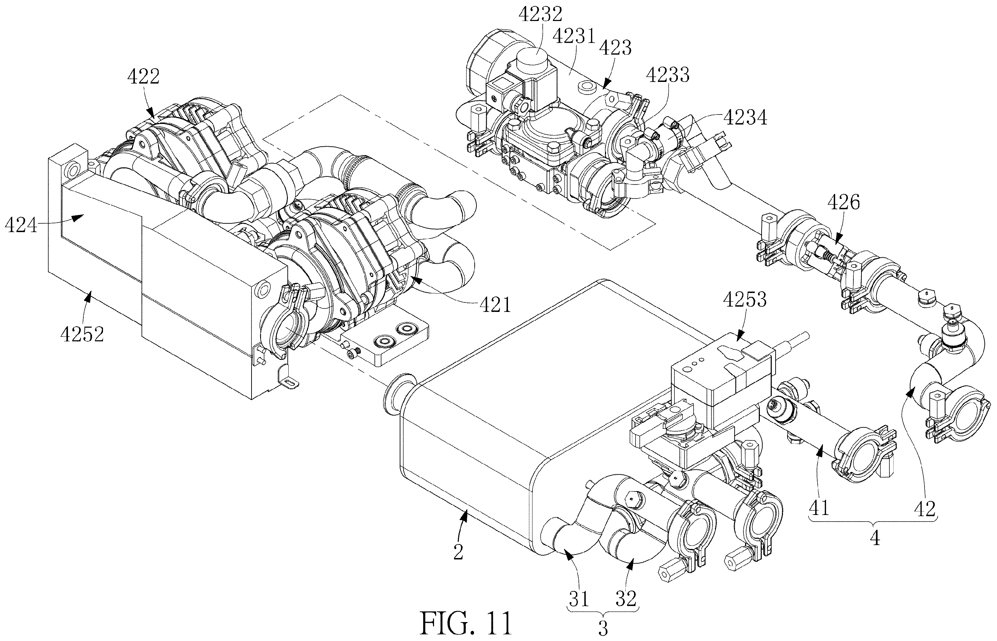

In one embodiment, as shown in FIG. 11, the buffering tank 4252 is L-shaped, and the fluidic storage tank 424 is disposed on an upper side of the L-shaped buffering tank 4252. In one embodiment, the fluidic storage tank 424 has a ramp arranged substantially at a middle segment thereof, so that the fluidic storage tank 424 has a larger cross-sectional area on one side of the ramp adjacent to the heat exchanger 2 and a smaller cross-sectional area on another side of the ramp away from the heat exchanger 2, thereby slowing down the velocity of the fluid (e.g., the coolant) therein to avoid generation of turbulence. In one embodiment, a vent of the buffering tank 4252 is located at the top side of the L-shaped buffering tank 4252, and the ramp of the fluidic storage tank 424 can be formed to reduce interference to the pipeline joints.

In one embodiment, the pressure adjustment unit 4251 includes an electromagnetic valve 4253 and a third pump unit 4254, the electromagnetic valve 4253 is arranged between and fluidly communicates the fluidic storage tank 424 and the buffering tank 4252, and the third pump unit 4254 is arranged between and fluidly communicates the fluidic storage tank 424 and the buffering tank 4252 and is connected in parallel to the electromagnetic valve 4253.

In one embodiment, the CDU equipment 100 (or the pressure adjustment unit 4251) includes a multiport 4255 that is fluidly coupled to the buffering tank 4252 and that is also fluidly coupled to the electromagnetic valve 4253 and the third pump unit 4254. In one embodiment, a fluidic supply port 4256 is fluidly coupled to the fluidic storage tank 424 through the multiport 4255 and the third pump unit 4254.

In one embodiment, when an internal pressure of the fluidic storage tank 424 is greater than a predetermined value, the pressure adjustment unit 4251 can be operated to open the electromagnetic valve 4253 to enable the multiport 4255 to connect the buffering tank 4252 and the electromagnetic valve 4253, thereby transmitting the coolant from the fluidic storage tank 424 to the buffering tank 4252. On the other hand, when the internal pressure of the fluidic storage tank 424 is lower than the predetermined value or when the volume of the coolant in the fluidic storage tank 424 is low, the pressure adjustment unit 4251 can be operated to enable the multiport 4255 to connect the buffering tank 4252 and the third pump unit 5424 and can drive the third pump unit 5424, thereby transmitting the coolant from the buffering tank 4252 to the fluidic storage tank 424.

It should be noted that, the multiport 4255 can be replaced by other components; for example, in one embodiment, the fluidic supply port 4256 can be connected to the fluidic storage tank 424, and the fluidic supply port 4256 and the fluidic storage tank 424 are provided with a fluidic supply pump therebetween; in another embodiment, the fluidic supply port 4256 can be connected to the buffering tank 4252, and the fluidic supply port 4256 and the buffering tank 4252 are provided with a fluidic supply pump therebetween.

### [Beneficial Effects of the Embodiments]

In conclusion, the interior space of the CDU equipment in the present invention is provided with a suitable configuration (e.g., the electronic circuit module placement region of the chassis is arranged above the fluidic module placement region) to achieve effective utilization, thereby effectively reducing the size of the CDU equipment.

The foregoing description of the exemplary embodiments of the invention has been presented only for the purposes of illustration and description and is not intended to be exhaustive or to limit the invention to the precise forms disclosed. Many modifications and variations are possible in light of the above teaching.

## Claims

1. A coolant distribution unit (CDU) equipment (100), **characterized by** comprising:
a chassis (1) having a fluidic module placement region (12) and an electronic circuit module placement region (11) that is arranged above the fluidic module placement region (12);
a heat exchanger (2) disposed in the fluidic module placement region (12);
a first fluidic path module (3) and a second fluidic path module (4) that are disposed in the fluidic module placement region (12) and that are fluidly coupled to the heat exchanger (2), wherein the first fluidic path module (3) includes a first input fluidic path (31) and a first output fluidic path (32), and the second fluidic path module (4) includes a second input fluidic path (41) and a second output fluidic path (42);
an electronic circuit module (5) disposed in the electronic circuit module placement region (11), wherein the electronic circuit module (5) includes a plurality of electronic circuit units (51) having a first pump driving unit (511); and
a plurality of transmission wires (6), wherein the second fluidic path module (4) has a first pump unit (421), and at least one of the plurality of transmission wires (6) is electrically connected to the first pump unit (421) and the first pump driving unit (511).

2. The CDU equipment (100) according to claim 1, wherein, along a transversal projection direction of the CDU equipment, a projection area of the electronic circuit module placement region (11) is at least partially overlapped with a projection area of the fluidic module placement region (12).

3. The CDU equipment (100) according to claim 1 or 2, further comprising a tray (7) assembled to the chassis (1), wherein the electronic circuit module placement region (11) is arranged in the tray (7).

4. The CDU equipment (100) according to claim 3, wherein the tray (7) is detachably assembled to the chassis (1).

5. The CDU equipment (100) according to claim 3 or **4,** wherein the CDU equipment (100) has no electronic circuit unit disposed outside of the tray (7).

6. The CDU equipment (100) according to one of claims 3 to 5, wherein the tray (7) is arranged above at least one of the first fluidic path module (3), the second fluidic path module (4), and the heat exchanger (2).

7. The CDU equipment (100) according to one of claims 3 to 6, wherein the tray (7) includes:
a first accommodating portion (71); and
a second accommodating portion (72) that is connected to and in fluid communication with the first accommodating portion (71).

8. The CDU equipment (100) according to claim 7, wherein the second accommodating portion (72) has two lateral walls (722) facing toward each other, and wherein at least one of the plurality of electronic circuit units (51) is assembled to one of the two lateral walls (722), and is spaced apart from another one of the two lateral walls (722) by a gap (G).

9. The CDU equipment (100) according to claim 7 or 8, wherein the second accommodating portion (72) has a bottom opening (723) arranged on a slot bottom thereof.

10. The CDU equipment (100) according to one of claims 1 to 9, further comprising a wire bracket (8) assembled to the chassis (1), wherein at least one of the plurality of transmission wires (6) is arranged along the wire bracket (8).

11. The CDU equipment (100) according to claim 10, wherein the wire bracket (8) is detachably assembled to the chassis (1).

12. The CDU equipment (100) according to one of claims 1 to 11, wherein the second fluidic path module (4) includes a filtering fluidic path (423) that is fluidly coupled to the heat exchanger (2), wherein the filtering fluidic path (423) includes a filter (4231), a solenoid valve (4232) being in fluid communication with an upstream of the filter (4231), and a check valve (4233) that is in fluid communication with a downstream of the filter (4231).

13. The CDU equipment (100) according to claim 12, wherein the filtering fluidic path (423) includes a bypass pipe (4234) having two ends that are respectively in fluid communication with an upstream of the solenoid valve (4232) and a downstream of the check valve (4233).

14. The CDU equipment (100) according to claim 12 or 13, wherein the filter (4231) is located at a corner of the chassis (1), and a part of the filter (4231) passes through the chassis (1).
